# EUROPEAN PATENT APPLICATION

(11) **EP 4 120 323 A1**
(43) Date of publication of application: **18.01.2023**
(21) Application number: 21768345.7
(22) Date of filing: 04.03.2021
(51) Int. Cl.: H01L 21/304

(54) **POLISHING COMPOSITION AND POLISHING METHOD**

(30) Priority: 13.03.2020 JP 2020044714
(71) Applicant: Fujimi Incorporated, Kiyosu-shi, Aichi 452-8502 (JP)
(72) Inventor: TSUCHIYA, Kohsuke, Kiyosu-shi, Aichi 452-8502 (JP); ICHITSUBO, Taiki, Kiyosu-shi, Aichi 452-8502 (JP)
(74) Representative: Grünecker Patent- und Rechtsanwälte PartG mbB
(86) International application number: PCT/JP2021/008368
(87) International publication number: WO 2021/182277

(57) **Abstract**

Provided is a polishing composition that contains a cellulose derivative and can improve the polishing removability and enhance the wettability of a polished surface of a silicon wafer. The polishing composition contains an abrasive, a cellulose derivative, a basic compound, and water. Here, the polishing composition has a zeta potential of -24.0 mV or more.

## Description

### [Technical Field]

The present invention relates to a polishing composition for a silicon wafer. The present invention also relates to a polishing method for a silicon wafer using the polishing composition. The present application claims priority based on Japanese Patent Application No. 2020-044714 filed on March 13, 2020, the entire contents of which application are incorporated herein by reference.

### [Background Art]

The surface of a silicon wafer used as a component of a semiconductor device or the like is generally finished into a high-quality mirror surface through a lapping step (rough polishing step) and a polishing step (fine polishing step). The polishing step typically includes a stock polishing step (preliminary polishing step) and a final polishing step (finish polishing step). For example, Patent Literature 1 is cited as technical literature on polishing compositions for silicon wafers.

### [Citation List]

### [Patent Literature]

[Patent Literature 1] Japanese Patent No. 5196819

### [Summary of Invention]

### [Technical Problem]

A silicon wafer is required to have a high-quality surface. Therefore, in addition to an abrasive and water, a polishing composition for such applications suitably contains a water-soluble polymer for the purpose of protecting the surface of an object to be polished, improving the wettability, and the like. By keeping the polished surface wetted with water (keeping a water layer adhering thereto), the direct adhesion of contaminants or the like in the air on the polished surface of the silicon wafer can be prevented and the surface defects due to the contaminants and the like can be reduced. The surface with such wettability tends to have suitable cleanability and can easily have higher quality by the cleaning. For example, Patent Literature 1 suggests a polishing composition containing hydroxyethyl cellulose as a water-soluble polymer.

The compositions containing a cellulose derivative as the water-soluble polymer, however, tend to have lower polishing removability due to a protective property of the cellulose derivative and therefore, it has been difficult to achieve both the polishing removability and the wettability of the polished surface. In addition, the conventional composition containing the cellulose derivative does not necessarily exhibit sufficient wettability.

The present invention has been made in view of the circumstances, and it is an object of the present invention to provide a polishing composition containing a cellulose derivative that can improve the polishing removability and enhance the wettability of a polished surface of a silicon wafer. It is another object of the present invention to provide a method for polishing a silicon wafer using such a polishing composition.

### [Solution to Problem]

According to the present specification, a polishing composition for a silicon wafer is provided. This polishing composition contains an abrasive, a cellulose derivative, a basic compound, and water. Here, the polishing composition has a zeta potential of -24.0 mV or more. By the polishing composition with such a constitution, the polishing removal rate is improved and the wettability after the polishing is enhanced.

In some preferred embodiments, the cellulose derivative used has a weight average molecular weight (Mw) of more than 80 × 10⁴. With the cellulose derivative as above, the aforementioned zeta potential is suitably achieved and the effect by the art disclosed herein is suitably exhibited.

In some preferred embodiments, the content of the cellulose derivative is 0.1 to 20 parts by weight per 100 parts by weight of the abrasive. When the content of the cellulose derivative is in the predetermined range relative to the content of the abrasives, the polishing removal rate tends to be improved further and the wettability also tends to be enhanced.

In some preferred embodiments, the content of the basic compound is 0.001% by weight or more and less than 0.1% by weight. With this constitution, the polishing composition can easily have a zeta potential in a suitable range and the polishing removal rate can be improved suitably.

In some preferred embodiments, the polishing composition has a pH of 8.0 or more and 12.0 or less. With the polishing composition having the pH as described above, the effect of improving the removability by the aforementioned zeta potential is suitably exhibited.

In some preferred embodiments, silica particles are used as the abrasive. By the composition containing the silica particles as the abrasive, the effect due to the art disclosed herein is suitably exhibited. In addition, the use of the silica particles can prevent the components derived from the abrasive from contaminating the silicon wafer. As the silica particles, for example, colloidal silica is preferable.

In some preferred embodiments, the silica particles have an average primary particle diameter of 5 nm or more and 100 nm or less. By the use of the silica particles with the average primary particle diameter of the predetermined value or more, the effect of improving the polishing removal rate can be obtained easily. In addition, by the silica particles with the average primary particle diameter of the predetermined value or less, the polished surface with high quality can be obtained easily.

The polishing composition is preferably used for polishing a surface made of silicon. When an object to be polished is the silicon wafer whose surface is made of silicon, the polishing composition disclosed herein can improve the polishing removal rate and enhance the wettability.

The polishing composition disclosed herein is preferably used for polishing the silicon wafer that has been subjected to lapping, for example. It is particularly preferable to be applied to a final polishing of silicon wafers.

In the present specification, a polishing method for a silicon wafer using any one of the polishing compositions disclosed herein is provided. The polishing method contains a stock polishing step and a final polishing step. In the final polishing step, a substrate to be polished is polished using a polishing composition containing an abrasive, a cellulose derivative, a basic compound, and water, and having a zeta potential of -24.0 mV or more. By such a polishing method, in the final polishing step, the polishing removal rate can be improved and at the same time, the wettability of the polished surface of the wafer can be enhanced, and accordingly, the surface of the silicon wafer with higher quality can be obtained.

### [Description of Embodiments]

Preferred embodiments of the present invention will be described below. Incidentally, matters other than those particularly mentioned in the present specification and necessary for the implementation of the present invention can be grasped as design matters of those skilled in the art based on the prior art in the relevant field. The present invention can be carried out based on the contents disclosed in this specification and technical common knowledge in the field.

### <Characteristics of Polishing Composition>

A polishing composition disclosed herein is characterized by having a zeta potential of -24.0 mV or more. Here, the zeta potential of the polishing composition refers to the zeta potential of the polishing composition measured by using a zeta potential measurement device. More specifically, it refers to the zeta potential measured regarding particles contained in the polishing composition. With the polishing composition having a zeta potential of -24.0 mV or more, it is possible to achieve both improved polishing removability and higher wettability of the polished surface after the polishing. In the implementation of the art disclosed herein, although it is unnecessary to clarify the mechanism about the contribution of the zeta potential of the polishing composition to the improved polishing removability and the higher wettability after the polishing, the following points are considered. It is considered that, regarding the polishing removability, when the polishing composition has a negative zeta potential, the higher zeta potential means that the electrostatic repulsion of the particles including abrasive decreases in the polishing composition and accordingly, the particles including the abrasives easily act on an object to be polished mechanically, resulting in the improved removability. In particular, it is considered that when the surface of the silicon wafer, which is the object to be polished, has a negative charge, the effect remarkably appears in the same manner as the particles in the polishing composition. Regarding the higher wettability, it is considered that when the particles in the polishing composition easily act on the surface of the silicon wafer, which is the surface to be polished, as described above, these particles act on the surface of the silicon wafer in a form containing the abrasive or the cellulose derivative, thereby contributing to higher hydrophilicity of the surface and higher wettability. The effects of the art disclosed herein, however, are not interpreted as being limited to the aforementioned mechanism only.

From the viewpoint of improving the polishing removal rate, the zeta potential of the polishing composition is preferably -22.0 mV or more, more preferably -21.0 mV or more, and still more preferably -20.0 mV or more, and may be -19.0 mV or more. The upper limit of the zeta potential is not set in particular, and is usually less than 0.0 mV, and from the viewpoints of the dispersibility of the polishing composition, the surface quality of the polished surface, and the like, the upper limit of the zeta potential is suitably -5.0 mV or less and preferably -10.0 mV or less, and may be, for example, -15.0 mV or less. The zeta potential of the polishing composition can be set based on the species and the content of the abrasives, the species, the molecular weight and the content of the cellulose derivative, the presence or absence of other additives (basic compound or water-soluble polymers other than cellulose derivatives) as well as the species and content thereof, the pH, and the like.

The zeta potential of the polishing composition can be measured using a known or commonly used zeta potential measurement device. Specifically, the zeta potential may be measured by a method described in examples below.

### <Abrasive>

The material and properties of the abrasive contained in the polishing composition disclosed herein are not particularly limited and can be appropriately selected according to the purpose of use and application of the polishing composition and the like. Examples of the abrasive include inorganic particles, organic particles, and organic-inorganic composite particles. Specific examples of the inorganic particles include oxide particles such as silica particles, alumina particles, cerium oxide particles, chromium oxide particles, titanium dioxide particles, zirconium oxide particles, magnesium oxide particles, manganese dioxide particles, zinc oxide particles, and red iron oxide particles; nitride particles such as silicon nitride particles and boron nitride particles; carbide particles such as silicon carbide particles and boron carbide particles; diamond particles; carbonates such as calcium carbonate and barium carbonate; and the like. Specific examples of the organic particles include polymethyl methacrylate (PMMA) particles, poly(meth)acrylic acid particles (here, (meth)acrylic acid means to be inclusive of acrylic acid and methacrylic acid), polyacrylonitrile particles, and the like. Such abrasives may be used singly or in combination of two or more kinds thereof.

As the above abrasives, the inorganic particles are preferable, and among them, particles composed of oxides of metals or metalloid are preferable, and the silica particles are particularly preferable. In the polishing compositions that can be used for polishing (for example, for final polishing) of objects to be polished having a surface made of silicon, such as silicon wafers, it is particularly significant to use the silica particles as the abrasive. The art disclosed herein can be preferably implemented, for example, in an embodiment in which the abrasive is substantially composed of silica particles. Here, "substantially" means that 95% by weight or more (preferably 98% by weight or more, more preferably 99% by weight or more and can be 100% by weight) of the particles constituting the abrasive is silica particles.

Specific examples of the silica particles include colloidal silica, fumed silica, precipitated silica, and the like. The silica particles may be used singly or in combination of two or more kinds thereof. The use of colloidal silica is particularly preferable, since a polished surface excellent in surface quality can be easily obtained after polishing. As the colloidal silica, for example, colloidal silica produced by an ion exchange method using water glass (sodium silicate) as a raw material and alkoxide method colloidal silica (colloidal silica produced by a hydrolytic condensation reaction of an alkoxysilane) can be preferably used. The colloidal silica may be used singly or in combination of two or more kinds thereof.

The true specific gravity (true density) of the abrasive constituting material (for example, silica forming silica particles) is preferably 1.5 or more, more preferably 1.6 or more, and still more preferably 1.7 or more. As the true specific gravity of the abrasive constituting material increases, the physical polishing ability tends to increase. The upper limit of the true specific gravity of the abrasive is not particularly limited and is typically 2.3 or less such as 2.2 or less. The true specific gravity of the abrasive (for example, silica particles) may be a value measured by a liquid displacement method using ethanol as a displacement liquid.

The average primary particle diameter of the abrasive (typically, silica particles) is not particularly limited; however, from the viewpoints of polishing removal rate and the like, the average primary particle diameter is preferably 5 nm or more and more preferably 10 nm or more. From the viewpoint of obtaining a higher polishing effect, the average primary particle diameter is preferably 15 nm or more and more preferably 20 nm or more (for example, more than 20 nm). Additionally, from the viewpoint of suppressing the local stress generated from the abrasive on the surface of the object to be polished, the average primary particle diameter of the abrasive is preferably 100 nm or less, more preferably 50 nm or less, and even more preferably 40 nm or less. Since it is easy to obtain a higher quality surface (for example, a surface having a low haze level) and so on, the art disclosed herein may be preferably implemented in an embodiment of using the abrasive having an average primary particle diameter of 35 nm or less (typically, less than 35 nm, more preferably 32 nm or less, and for example, less than 30 nm).

In the present specification, the average primary particle diameter refers to the particle diameter (BET particle diameter) calculated by a formula of average primary particle diameter (nm) = 6000/(true density (g/cm³) × BET value (m²/g)) from the specific surface area (BET value) measured by the BET method. For example, in the case of the silica particles, the average primary particle diameter can be calculated from average primary particle diameter (nm) = 2727/BET value (m²/g). The specific surface area can be measured, for example, by using a surface area measuring apparatus "Flow Sorb II 2300" manufactured by Micromeritics Instrument Corporation.

The average secondary particle diameter of the abrasive is not particularly limited and can be appropriately selected from the range of about 15 nm to 300 nm, for example. From the viewpoint of improving the polishing removal efficiency, the average secondary particle diameter is preferably 30 nm or more and more preferably 35 nm or more. In some embodiments, the average secondary particle diameter may be, for example, 40 nm or more, 45 nm or more, preferably 50 nm or more, further 60 nm or more, and 65 nm or more (for example, 70 nm or more). Usually, the average secondary particle diameter is suitably 250 nm or less, preferably 200 nm or less, and more preferably 150 nm or less. In some embodiments, the average secondary particle diameter may be 120 nm or less and 100 nm or less.

In the present specification, the average secondary particle diameter refers to the particle diameter measured by a dynamic light scattering method (volume average particle diameter). The average secondary particle diameter of the abrasive can be measured by the dynamic light scattering method using, for example, "NANOTRAC (registered trademark) UPA-UT151" manufactured by NIKKISO CO., LTD.

The shape (outer shape) of the abrasive may be globular or non-globular. Specific examples of the non-globular particles include particles of a peanut shape (that is, the shape of the peanut shell), a cocoon shape, a conpeito shape, a rugby ball shape, and the like. For example, the abrasive in which most of the particles have a peanut shape or a cocoon shape can preferably be used.

Although not particularly limited, the average value of the major axis/minor axis ratio (average aspect ratio) of the abrasive is in principle 1.0 or more, preferably 1.05 or more, and even more preferably 1.1 or more. By increasing the average aspect ratio, it is possible to achieve higher polishing removal efficiency. From the viewpoints of reducing scratching and the like, the average aspect ratio of the abrasive is preferably 3.0 or less, more preferably 2.0 or less, and even more preferably 1.5 or less.

The shape (outer shape) and the average aspect ratio of the abrasive can be grasped by, for example, observation with an electron microscope. A specific procedure for grasping the average aspect ratio includes, for example, drawing a minimum rectangle circumscribing each particle image for a predetermined number of silica particles (for example, 200 particles) for which the shape of an independent particle can be recognized by using a scanning electron microscope (SEM). Then, with respect to the rectangle drawn for each particle image, a value obtained by dividing the length of the longer side (value of maj or axis) by the length of the shorter side (value of minor axis) is calculated as the major axis/minor axis ratio (aspect ratio). By arithmetically averaging the aspect ratios of the predetermined number of particles, the average aspect ratio can be obtained.

### <Cellulose Derivative>

The polishing composition disclosed herein contains the cellulose derivative. The cellulose derivative is a polymer containing a β-glucose unit as a main repeat unit. Specific examples of the cellulose derivative include hydroxyethyl cellulose (HEC), hydroxypropyl cellulose, hydroxyethyl methyl cellulose, hydroxypropyl methyl cellulose, methylcellulose, ethylcellulose, ethyl hydroxyethyl cellulose, carboxymethyl cellulose, and the like, among which HEC is preferable. The cellulose derivative may be used singly or in combination of two or more kinds thereof.

The Mw of the cellulose derivative used in the polishing composition disclosed herein can be a suitable value in the range where the zeta potential of the polishing composition is the predetermined value or more, and therefore is not limited to the particular range. The Mw of the cellulose derivative can be, for example, 30 × 10⁴ or more and may be 50 × 10⁴ or more. From the viewpoint of improving the polishing removal rate, the Mw of the cellulose derivative is preferably more than 80 × 10⁴, more preferably more than 100 × 10⁴, still more preferably more than 120 × 10⁴, and particularly preferably more than 140 × 10⁴ and may be, for example, more than 150 × 10⁴. The cellulose derivative tends to be adsorbed by the abrasive(s) (suitably silica particles), and in such a case, it is considered that the cellulose derivative with the larger Mw has a larger effect of reducing the electrostatic repulsion of the abrasives. The art disclosed herein, however, is not limited to this interpretation. The upper limit of the Mw of the cellulose derivative can be 300 × 10⁴ or less, is suitably 250 × 10⁴ or less, and may be 200 × 10⁴ or less from the viewpoints of the dispersibility and the like.

The relation between the weight average molecular weight (Mw) and the number average molecular weight (Mn) of the cellulose derivative is not particularly limited. For example, a molecular weight distribution (Mw/Mn) of the cellulose derivative is 4.0 or more and can be more than 5.0. The Mw/Mn may be 8.0 or more (for example, 9.0 or more). In the cellulose derivative whose Mw/Mn is the predetermined value or more, the act of the low-molecular-weight compound and the act of the high-molecular-weight compound can be well balanced. From the viewpoints of preventing the aggregation of the polishing composition and stabilizing the performance, the Mw/Mn can be 20 or less, is suitably 15 or less, and may be 12 or less.

In the present specification, the Mw and Mn of the cellulose derivative may be values based on gel permeation chromatography (GPC) (aqueous system, in terms of polyethylene oxide). A GPC measurement device can be "HLC-8320GPC" manufactured by Tosoh Corporation. Measurement conditions are as follows:

### [GPC Measurement Conditions]

Sample concentration: 0.1% by weight
Column: TSKgel GMPW_{XL}
Detector: differential refractometer
Eluent: 100 mM of sodium nitrate aqueous solution
Flow rate: 1.0 mL/min
Measurement temperature: 40°C
Amount of sample injection: 200 µL
Standard sample: polyethylene oxide

Although not particularly limited, the content of the cellulose derivative in the polishing composition can be, for example, 0.01 parts by weight or more and may be 0.05 parts by weight or more per 100 parts by weight of the abrasive in the polishing composition. From the viewpoint of better exploitation of the effect due to use of the cellulose derivative, the content is preferably 0.1 parts by weight or more, more preferably 1 part by weight or more, and still more preferably 2 parts by weight or more. From the viewpoints of filtration ability of the polishing composition and the like, the content of the cellulose derivative per 100 parts by weight of the abrasive is usually 50 parts by weight or less, suitably 30 parts by weight or less, for example, and preferably 20 parts by weight or less, and may be 10 parts by weight or less, 8 parts by weight or less, and 6 parts by weight or less (for example, 4 parts by weight or less).

### <Basic Compound>

The polishing composition disclosed herein contains a basic compound. The basic compound may be appropriately selected from various basic compounds that have a function of raising the pH of aqueous solutions in which the compounds are dissolved in water. For example, an organic or inorganic basic compound containing nitrogen, a basic compound containing phosphorus, an alkali metal hydroxide, an alkaline earth metal hydroxide, various carbonates, bicarbonates, and the like may be used. Examples of the basic compound containing nitrogen include a quaternary ammonium compound, ammonia, an amine (preferably, water-soluble amine), and the like. Examples of the basic compound containing phosphorus include a quaternary phosphonium compound. Such basic compounds may be used singly or in combination of two or more kinds thereof.

Specific examples of the alkali metal hydroxide include potassium hydroxide, sodium hydroxide, and the like. Specific examples of the carbonate and bicarbonate include ammonium hydrogen carbonate, ammonium carbonate, potassium hydrogen carbonate, potassium carbonate, sodium hydrogen carbonate, sodium carbonate, and the like. Specific examples of the amine include methylamine, dimethylamine, trimethylamine, ethylamine, diethylamine, triethylamine, ethylenediamine, monoethanolamine, N-(β-aminoethyl) ethanolamine, hexamethylenediamine, diethylenetriamine, triethylenetetramine, piperazine anhydride, piperazine hexahydrate, 1-(2-aminoethyl) piperazine, N-methylpiperazine, guanidine, azoles such as imidazole and triazole, and the like. Specific examples of the quaternary phosphonium compound include a quaternary phosphonium hydroxide such as tetramethylphosphonium hydroxide and tetraethylphosphonium hydroxide.

A quaternary ammonium salt (typically, strong base) such as a tetraalkylammonium salt or a hydroxyalkyltrialkylammonium salt can be used as the quaternary ammonium compound. An anion component in the quaternary ammonium salt may be, for example, OH⁻, F⁻, Cl⁻, Br⁻, I⁻, ClO₄⁻, or BH₄⁻. Examples of the quaternary ammonium compound include a quaternary ammonium salt with OH⁻ as an anion, that is, a quaternary ammonium hydroxide. Specific examples of the quaternary ammonium hydroxide include a tetraalkylammonium hydroxide such as tetramethylammonium hydroxide, tetraethylammonium hydroxide, tetrapropylammonium hydroxide, tetrabutylammonium hydroxide, tetrapentylammonium hydroxide, and tetrahexylammonium hydroxide; a hydroxyalkyltrialkylammonium hydroxide such as 2-hydroxyethyltrimethylammonium hydroxide (also referred to as choline); and the like.

The basic compound in the art disclosed herein is preferably at least one basic compound selected from an alkali metal hydroxide, a quaternary ammonium hydroxide, and ammonia. Among these, the quaternary ammonium hydroxide and ammonia are more preferable, and ammonia is particularly preferable. The art disclosed herein may be preferably implemented in an embodiment in which the basic compound contained in the polishing composition is substantially composed of ammonia. In this embodiment, the content of the basic compound other than ammonia (for example, quaternary ammonium hydroxide) may be 1/10 or less (for example, 1/30 or less) of the content of ammonia on a weight basis, and in the polishing composition, less than 0.003% by weight (moreover, less than 0.001% by weight). In such an embodiment, the zeta potential of the polishing composition can be easily set to the predetermined value or more and the effect by the art disclosed herein can be suitably exhibited.

Although not particularly limited, the content of the basic compound in the polishing composition can be, for example, 0.01 parts by weight or more and may be 0.05 parts by weight or more per 100 parts by weight of the abrasive in the polishing composition. From the viewpoint of better exploitation of the effect due to use of the basic compound, the content is preferably 0.1 parts by weight or more, more preferably 0.5 parts by weight or more, and still more preferably 1.0 parts by weight or more. The content of the basic compound per 100 parts by weight of the abrasive can be 30 parts by weight or less, is suitably less than 10 parts by weight and preferably 5 parts by weight or less, and may be 3 parts by weight or less. When the content of the basic compound is set in the predetermined range with respect to the amount of abrasive, the zeta potential of the polishing composition can be easily set to the predetermined value or more and the polishing removal rate can be improved further.

Although not particularly limited, the content of the basic compound in the polishing composition can also be specified by the relation between the specific surface area and the content of the abrasive contained in the polishing composition. Specifically, specific surface area of abrasive × content of abrasive/content of basic compound can be, for example, 1000 or more and may be 1500 or more. From the viewpoint of better exploitation of the effect due to use of the basic compound, the aforementioned value is preferably 1750 or more, and is 2000 or more, for example. Additionally, specific surface area of abrasive × content of abrasive/content of basic compound can be 15000 or less, is suitably less than 12000 and preferably 11000 or less, and may be 10000 or less (for example, 8000 or less). When the content of the basic compound is set in the predetermined range with respect to the amount of abrasive, the zeta potential of the polishing composition can be easily set to the predetermined value or more and the polishing removal rate can be improved further. Here, the specific surface area of the abrasive refers to the specific surface area (BET value) measured the BET method.

### <Optional Polymer>

The polishing composition disclosed herein may contain, as an optional component, a water-soluble polymer (hereinafter also referred to as "optional polymer") other than the cellulose derivative as long as it does not significantly impair the effects of the present invention. For example, a starch derivative, a polyvinyl alcohol-based polymer, an N-vinyl-based polymer, an N-(meth)acryloyl-based polymer, or the like can be used as the optional polymer. Examples of the starch derivative include pregelatinized starch, pullulan, carboxymethyl starch, cyclodextrin, and the like. The polyvinyl alcohol-based polymer refers to a polymer containing a vinyl alcohol unit (hereinafter also referred to as "VA unit") as the repeat unit. The polyvinyl alcohol-based polymer may contain only the VA unit as the repeat unit or may contain a repeat unit other than the VA unit (hereinafter also referred to as "non-VA unit") in addition to the VA unit. The polyvinyl alcohol-based polymer may alternatively be non-modified polyvinyl alcohol (non-modified PVA) or modified polyvinyl alcohol (modified PVA). The N-vinyl-based polymer may be a homopolymer or copolymer of N-vinyl-based monomers. Specific examples of the N-vinyl-based polymer include a homopolymer of N-vinyl pyrrolidone (VP), a copolymer having a copolymerization ratio of VP of 70% by weight or more, and the like. The N-(meth)acryloyl-based polymer may be a homopolymer or copolymer of N-(meth)acryloyl-based monomers. Specific examples of the N-(meth)acryloyl-based polymer include a homopolymer of N-isopropylacrylamide (NIPAM), a copolymer having a copolymerization ratio of NIPAM of 70% by weight or more, a homopolymer of N-acryloylmorpholine (ACMO), a copolymer having a copolymerization ratio of ACMO of 70% by weight or more, and the like. The optional polymer is preferably nonionic. The content of the optional polymer per 100 parts by weight of the cellulose derivative is usually less than 100 parts by weight and suitably less than 50 parts by weight, and may be less than 30 parts by weight, less than 10 parts by weight, less than 5 parts by weight, and less than 1 part by weight. The art disclosed herein may be preferably implemented in an embodiment that does not substantially contain the optional polymer.

### <Surfactant>

The polishing composition disclosed herein may optionally contain a surfactant as required. With the surfactant contained in the polishing composition, the haze of the polished surface of the object to be polished can be reduced more. The surfactant that can be used may be anionic, cationic, nonionic, or amphoteric. Usually, the anionic or nonionic surfactant may be preferably used. From the viewpoints of reducing foamability and enabling easy pH adjustment, the nonionic surfactant is more preferable. Examples of the nonionic surfactant include oxyalkylene polymers such as polyethylene glycol, polypropylene glycol, and polytetramethylene glycol; polyoxyalkylene derivatives (for example, polyoxyalkylene adducts) such as polyoxyethylene alkyl ethers, polyoxyethylene alkyl phenyl ethers, polyoxyethylene alkyl amines, polyoxyethylene fatty acid esters, polyoxyethylene glyceryl ether fatty acid esters, and polyoxyethylene sorbitan fatty acid esters; copolymers of a plurality of kinds of oxyalkylenes (for example, diblock copolymer, triblock copolymer, random copolymer, and alternating copolymer); and the like. As the surfactant to be contained, the surfactant with a polyoxyalkylene structure is preferable. The surfactant may be used singly or in combination of two or more kinds thereof.

Specific examples of the nonionic surfactant with the polyoxyalkylene structure include a block copolymer of ethylene oxide (EO) and propylene oxide (PO) (a diblock copolymer, a PEO (polyethylene oxide)-PPO (polypropylene oxide)-PEO triblock copolymer, a PPO-PEO-PPO triblock copolymer, and the like), a random copolymer of EO and PO, polyoxyethylene glycol, polyoxyethylene propyl ether, polyoxyethylene butyl ether, polyoxyethylene pentyl ether, polyoxyethylene hexyl ether, polyoxyethylene octyl ether, polyoxyethylene-2-ethylhexyl ether, polyoxyethylene nonyl ether, polyoxyethylene decyl ether, polyoxyethylene isodecyl ether, polyoxyethylene tridecyl ether, polyoxyethylene lauryl ether, polyoxyethylene cetyl ether, polyoxyethylene stearyl ether, polyoxyethylene isostearyl ether, polyoxyethylene oleyl ether, polyoxyethylene phenyl ether, polyoxyethylene octyl phenyl ether, polyoxyethylene nonyl phenyl ether, polyoxyethylene dodecyl phenyl ether, polyoxyethylene styrenated phenyl ether, polyoxyethylene lauryl amine, polyoxyethylene stearyl amine, polyoxyethylene oleyl amine, polyoxyethylene monolauric acid ester, polyoxyethylene monostearic acid ester, polyoxyethylene distearic acid ester, polyoxyethylene monooleic acid ester, polyoxyethylene dioleic acid ester, polyoxyethylene sorbitan monolaurate, polyoxyethylene sorbitan monopalmitate, polyoxyethylene sorbitan monostearate, polyoxyethylene sorbitan monooleate, polyoxyethylene sorbitan trioleate, polyoxyethylene sorbit tetraoleate, polyoxyethylene castor oil, polyoxyethylene hydrogenated castor oil, and the like. Examples of the preferred surfactant include the block copolymer of EO and PO (particularly, PEO-PPO-PEO triblock copolymer), the random copolymer of EO and PO, and polyoxyethylene alkyl ether (for example, polyoxyethylene decyl ether).

The surfactant has a molecular weight of less than 1 × 10⁴, typically. From the viewpoints of the filtration ability of the polishing composition, the cleanability of the polished object, and the like, the molecular weight is suitably less than 7000, and from the viewpoint of haze reduction, the molecular weight is preferably less than 4000 and more preferably less than 3500. From the viewpoints of the surface activity performance and the like, the molecular weight of the surfactant is usually suitably 200 or more, and from the viewpoints of the effect of the haze reduction and the like, the molecular weight of the surfactant is preferably 250 or more (for example, 300 or more). The range of more preferable molecular weight of the surfactant may vary according to the kind of the surfactant. For example, when polyoxyethylene alkyl ether is used as the surfactant, the molecular weight thereof is preferably 1500 or less and may be 1000 or less (for example, 500 or less). When the PEO-PPO-PEO triblock copolymer is used as the surfactant, for example, the molecular weight thereof may be, for example, 500 or more, 1000 or more, and further, 2000 or more (for example, 2500 or more). Note that the molecular weight of the surfactant may be the weight average molecular weight (Mw) (aqueous system, in terms of polyethylene oxide) obtained by the aforementioned GPC or the molecular weight calculated from the chemical formula.

When the polishing composition disclosed herein contains the surfactant, the content thereof is not particularly limited as long as the content is in the range that does not significantly impair the effects of the present invention. Usually, from the viewpoints of the cleanability and the like, the content of the surfactant per 100 parts by weight of the abrasive is suitably 20 parts by weight or less, preferably 15 parts by weight or less, and more preferably 10 parts by weight or less (for example, 6 parts by weight or less). The content per 100 parts by weight of the abrasive can be, for example, 5 parts by weight or less, 4 parts by weight or less, and 3 parts by weight or less. From the viewpoint of better exploitation of the effect due to use of the surfactant, the content of the surfactant per 100 parts by weight of the abrasive is suitably 0.001 parts by weight or more and preferably 0.005 parts by weight or more, and may be 0.01 parts by weight or more and 0.05 parts by weight or more. In some preferred embodiments, the content of the surfactant per 100 parts by weight of the abrasive may be 0.1 parts by weight or more from the viewpoint of the haze reduction. The polishing composition disclosed herein may be preferably implemented even in an embodiment that does not substantially contain the surfactant.

### <Water>

The polishing composition disclosed herein typically contains water. Ion exchanged water (deionized water), pure water, ultrapure water, distilled water, and the like may be preferably used as the water. In order to minimize the inhibition of the action of other components contained in the polishing composition, the total content of transition metal ions in the water used is preferably, for example, 100 ppb or less. For example, the purity of water can be increased by operations such as removal of impurity ions with an ion exchange resin, removal of contaminants with a filter, and distillation.

### <Other Components>

The polishing composition disclosed herein may optionally contain a well-known additive that may be used in polishing compositions (typically, a polishing composition for a silicon wafer), such as a chelating agent, an organic acid, an organic acid salt, an inorganic acid, an inorganic acid salt, an antiseptic agent, and an antifungal agent, as long as it does not significantly impair the effects of the present invention. The polishing composition disclosed herein may be preferably implemented in an embodiment that does not substantially contain the chelating agent.

The polishing composition disclosed herein is preferably substantially free of an oxidant. This is because the polishing removal rate can be lowered due to an oxide layer generated by oxidizing the surface of the object to be polished (silicon wafer) while the polishing composition containing the oxidant is supplied to the object to be polished. Specific examples of the oxidant as used herein include hydrogen peroxide (H₂O₂), sodium persulfate, ammonium persulfate, sodium dichloroisocyanurate, and the like. The polishing composition being substantially free of the oxidant means that the oxidant is not contained at least intentionally.

### <pH>

The pH of the polishing composition disclosed herein is usually suitably 8.0 or more, preferably 8.5 or more, more preferably 9.0 or more, and still more preferably 9.5 or more such as 10.0 or more. When the pH of the polishing composition increases, the polishing removal efficiency tends to be improved. As the polishing composition disclosed herein has higher pH, in the polishing composition, the particles including the abrasive and the like tend to have larger electrostatic repulsion, and the surface of the silicon wafer, which is the object to be polished, also tends to be negatively charged. By the art disclosed herein, increasing the zeta potential of the polishing composition with the pH in the above range enables the particles in the polishing composition to act on the surface of the silicon wafer suitably. Meanwhile, from the viewpoints of preventing dissolution of the abrasive (such as silica particles) and suppressing a decrease in the mechanical polishing effect by the abrasive, the pH of the polishing composition is suitably 12.0 or less, preferably 11.8 or less, more preferably 11.5 or less, and still more preferably 11.0 or less.

In the art disclosed herein, the pH of the composition can be grasped by performing three-point calibration using a standard buffer solution (phthalate pH buffer solution, pH: 4.01 (25°C), neutral phosphate pH buffer solution, pH: 6.86 (25°C), carbonate pH buffer solution, pH: 10.01 (25°C)) by using a pH meter (for example, glass electrode type hydrogen ion concentration indicator (model type F-23) manufactured by Horiba Ltd.), placing a glass electrode in the composition to be measured, and measuring a pH value after the composition has been stabilized for 2 minutes or longer.

### <Polishing Slurry>

Typically, the polishing composition disclosed herein is supplied to the object to be polished in the form of a polishing slurry containing the polishing composition, and is used for polishing the object to be polished. The polishing slurry may be prepared, for example, by diluting (typically diluting with water) any of the polishing compositions disclosed herein. Alternatively, the polishing composition may be used as it is as the polishing slurry. That is, the concept of the polishing composition in the art disclosed herein is inclusive of a polishing slurry (working slurry) that is supplied to an object to be polished and used for polishing the object to be polished, and a concentrate (that is, a stock solution of a polishing slurry) that is used as a polishing slurry after dilution. Another example of the polishing slurry containing the polishing composition disclosed herein includes a polishing slurry prepared by adjusting the pH of the composition.

The content of the abrasive in the polishing composition is not particularly limited, and is typically 0.01% by weight or more, and preferably 0.05% by weight or more. The content thereof may be 0.10% by weight or more, 0.20% by weight or more, 0.30% by weight or more, and 0.40% by weight or more, for example. A higher polishing removal speed may be achieved by increasing the content of the abrasive. The content is suitably 10% by weight or less, preferably 7% by weight or less, more preferably 5% by weight or less, and still more preferably 2% by weight or less, and may be 1% by weight or less and 0.5% by weight or less, for example. Accordingly, a surface having lower haze can be achieved. The aforementioned content of the abrasive can preferably be used in an embodiment in which the polishing composition is used in the form of the polishing slurry.

The concentration of the cellulose derivative in the polishing composition is not particularly limited and may be, for example, 0.0001 % by weight or more, and from the viewpoint of better exploitation of the effect due to use of the cellulose derivative, the concentration is suitably 0.0005% by weight or more. From the viewpoints of improving the polishing removal rate, enhancing the wettability of the polished surface and the like, the concentration of the cellulose derivative is preferably 0.001% by weight or more and more preferably 0.002% by weight or more, and for example, may be 0.004% by weight or more and 0.008% by weight or more. From the viewpoints of the polishing removal efficiency and the like, the concentration of the cellulose derivative is usually preferably 0.2% by weight or less and more preferably 0.1% by weight or less, and may be 0.05% by weight or less (for example, 0.03% by weight or less). The aforementioned concentration of the cellulose derivative can preferably be used in an embodiment in which the polishing composition is used in the form of the polishing slurry.

When the polishing composition disclosed herein contains the basic compound, the concentration of the basic compound in the polishing composition is not particularly limited. From the viewpoints of improving the polishing removal rate and the like, the concentration is usually suitably 0.0005% by weight or more, preferably 0.001% by weight or more, and more preferably 0.005% by weight or more. From the viewpoints of the haze reduction and the like, the concentration is suitably less than 0.1% by weight, preferably less than 0.05% by weight, and more preferably less than 0.03% by weight (for example, less than 0.025% by weight). With the content of the basic compound set in the predetermined range, the zeta potential of the polishing composition can be easily set to the predetermined value or more and the polishing removal rate can be improved further. The aforementioned concentration of the basic compound can preferably be used in an embodiment in which the polishing composition is used in the form of the polishing slurry.

### <Concentrate>

The polishing composition disclosed herein may be in a concentrated form before being supplied to the object to be polished (that is, the concentrated form may be the form of the concentrate of the polishing slurry and can be grasped as a stock solution of the polishing slurry). The polishing composition in such a concentrated form is suitable from the viewpoints of convenience in manufacturing, distribution, storage, cost reduction, and the like. The concentration factor is not particularly limited, and can be, for example, about 2 times to 100 times in terms of volume, and is usually suitably about 5 times to 50 times (for example, about 10 times to 40 times).

Such a concentrate can be used in an embodiment in which the concentrate is diluted at a desired timing to prepare the polishing slurry (working slurry) and this polishing slurry is supplied to the object to be polished. The dilution can be carried out, for example, by adding water to the concentrate and mixing.

### <Preparation of Polishing Composition>

The polishing composition used in the art disclosed herein may be in a one-agent type or a multi-agent type such as a two-agent type. For example, the polishing slurry can be prepared by mixing a part A containing at least the abrasive among the constituent components of the polishing composition and a part B containing at least a part of the remaining components, and mixing and diluting these at an appropriate timing as needed.

A method for preparing the polishing composition is not particularly limited. For example, the components constituting the polishing composition may be mixed using a well-known mixing device such as a blade stirrer, an ultrasonic disperser, or a homomixer. The mode of mixing these components is not particularly limited, and for example, all the components may be mixed at once or may be mixed in a properly set order.

### <Application>

The polishing composition according to the art disclosed herein can be used particularly preferably in polishing surfaces made of silicon (typically, polishing silicon wafers). Atypical example of the silicon wafer referred to herein is a silicon single crystal wafer, for example, a silicon single crystal wafer obtained by slicing a silicon single crystal ingot.

The polishing composition disclosed herein can be preferably used in a polishing step of the object to be polished (for example, silicon wafer). Prior to the polishing step using the polishing composition disclosed herein, the object to be polished may be subjected to a general treatment that can be applied to the object to be polished in a step upstream of the polishing step, such as lapping or etching.

The polishing composition disclosed herein can be preferably used, for example, in polishing of the object to be polished (for example, silicon wafer), which has been prepared to have a surface state with a surface roughness of 0.01 nm to 100 nm in an upstream step. The surface roughness Ra of the object to be polished can be measured using, for example, a laser scanning type surface roughness meter "TMS-3000WRC" manufactured by Schmitt Measurement Systems Inc. The use of the polishing composition in the final polishing or the polishing immediately therebefore is effective, and the use thereof in the final polishing is particularly preferred. Here, the final polishing refers to the last polishing step in the process of manufacturing the object (that is, a step after which no further polishing is performed).

### <Polishing>

The polishing composition disclosed herein can be used for polishing the object to be polished in an embodiment including, for example, the following operations. Hereinafter, a favorable embodiment of a method for polishing the object to be polished (for example, silicon wafer) by using the polishing composition disclosed herein will be described.

That is to say, the polishing slurry containing any of the polishing compositions disclosed herein is prepared. The preparation of the polishing slurry may include preparing the polishing slurry by adjusting the concentration of the polishing composition (for example, by dilution) or adjusting the pH, for example. Alternatively, the polishing composition may be used as it is as the polishing slurry

Next, the polishing slurry is supplied to the object to be polished and polishing is performed by a conventional method. For example, in the case of the final polishing of a silicon wafer, typically, the silicon wafer that has been subjected to the lapping step is set in a general polishing machine and the polishing slurry is supplied to the surface to be polished of the silicon wafer through a polishing pad of the polishing machine. Typically, the polishing pad is pressed against the surface to be polished of the silicon wafer and the two are moved (for example, rotated) relative to each other while continuously supplying the polishing slurry. Through this polishing step, the polishing of the object to be polished is completed.

The polishing pad used in the polishing step is not particularly limited. For example, a polishing pad of a foamed polyurethane type, a nonwoven fabric type, a suede type, or the like can be used. Each polishing pad may or may not contain the abrasives. Usually, a polishing pad not containing the abrasives is preferably used.

The object to be polished, which has been polished using the polishing composition disclosed herein, is typically cleaned. Cleaning can be carried out using an appropriate cleaning solution. The cleaning solution to be used is not particularly limited, and for example, an SC-1 cleaning solution (mixed solution of ammonium hydroxide (NH₄OH), hydrogen peroxide (H₂O₂), and water (H₂O)), an SC-2 cleaning solution (mixed solution of HCl, H₂O₂, and H₂O), and the like generally used in the field of semiconductors and the like can be used. The temperature of the cleaning solution can be, for example, in the range from room temperature (typically about 15°C to 25°C) to about 90°C. From the viewpoint of improving the cleaning effect, the cleaning solution at about 50°C to 85°C can be preferably used.

### [Examples]

Several examples relating to the present invention will be described below; however, the present invention is not intended to be limited to these examples. In the following description, "%" is on a weight basis.

### <Preparation of Polishing Compositions>

### (Examples 1 to 3, and Comparative Example 1)

The abrasive, the cellulose derivative, the basic compound, and deionized water (DIW) were mixed to prepare a polishing composition concentrate according to each example. As the abrasive, colloidal silica with an average primary particle diameter of 35 nm was used. As the cellulose derivative, hydroxyethyl cellulose (HEC) with the Mw shown in Table 1 was used. As the basic compound, ammonia was used. By diluting the obtained polishing composition concentrate with deionized water (DIW) 20 times in volume ratio, the polishing composition containing 0.46% of the abrasive, 0.012% of the cellulose derivative, and 0.01% of the basic compound was obtained.

### <Measurement of Zeta Potential>

For each polishing composition, the zeta potential was measured under the following conditions using a zeta potential measurement device. As the measurement device, "Zetasizer nano ZSP" manufactured by Malvern Panalytical Ltd. was used. The measurement results are shown in the respective columns in Table 1.

### [Zeta Potential Measurement Conditions]

Dispersion medium: water
Measurement temperature: 25°C
Model: Smoluchowski

### <Polishing Removal Rate>

### (Polishing of Silicon Wafer)

A silicon wafer (conductive type: P type, crystal orientation: <100>, COP (Crystal Originated Particle, crystal defect)-free) with a diameter of 200 mm was prepared as the object to be polished, and this silicon wafer was immersed in an HF aqueous solution (HF concentration: 2%) for 30 seconds to remove the oxide layer, and was polished under the following conditions using the polishing composition according to each example as the polishing slurry.

### [Polishing Conditions]

Polishing machine: single wafer polishing machine manufactured by Okamoto Machine Tool Works, Ltd., model "PNX-322"
Polishing pressure: 15 kPa
Platen rotational speed: 30 rpm
Head (carrier) rotational speed: 30 rpm
Polishing pad: polishing pad manufactured by Fujibo Ehime Co., Ltd., product name "POLYPAS 27 NX"
Flow rate of polishing slurry: 0.4 L/min (one-way)
Temperature of polishing slurry: 20°C
Polishing time: 600 seconds

### (Cleaning of Silicon Wafer)

The polished silicon wafer was removed from the polishing machine, and cleaned (SC-1 cleaning) by five-minute immersion in a cleaning solution of NH₄OH (29%) : H₂O₂ (31%) : deionized water = 1: 1 : 12 (volume ratio). After that, the polished silicon wafer was immersed in deionized water with an ultrasonic oscillator in operation, and then dried with a spin dryer.

### (Evaluation)

The weights of the silicon wafer before and after the polishing were measured, and from the weight difference, the polishing removal rate [nm/min] was obtained.

### <Water Repelling Distance after Polishing>

The silicon wafer was polished under the following conditions and the surface of the silicon wafer (surface to be polished) was cleaned for 10 seconds with flowing water at a flow rate of 7 L/min. The cleaned wafer was placed at rest with a diagonal line of the wafer in a vertical direction (vertical state), and a water repelling distance was measured after 3 minutes. Specifically, the length of a section, in the diagonal line on the surface of the wafer, that is not wetted with water from an edge of the wafer was measured and this value was recorded as the water repelling distance [mm].

The water repelling distance is an index of the wettability of the surface to be polished, and the water repelling distance tends to decrease as the surface to be polished has higher wettability. The maximum value of the water repelling distance in the present evaluation test is the length of the diagonal line of the wafer, that is, about 85 mm. The measurement results are shown in the respective columns in Table 1.

### (Polishing of Silicon Wafer)

A silicon wafer (conductive type: P type, crystal orientation: <100>, COP free) of 60 mm square was prepared as the object to be polished, and this silicon wafer was immersed in an HF aqueous solution (HF concentration: 2%) for 30 seconds to remove the oxide layer, and was polished under the following conditions using the polishing composition according to each example as the polishing slurry.

### [Polishing Conditions]

Polishing machine: compact desktop lapping system manufactured by ENGIS JAPAN Corporation, model "EJ-380IN"
Polishing pressure: 21 kPa
Platen rotational speed: 30 rpm
Head (carrier) rotational speed: 30 rpm
Polishing pad: polishing pad manufactured by Fujibo Ehime Co., Ltd., product name "POLYPAS 27 NX"
Flow rate of polishing slurry: 0.6 L/min (one-way)
Temperature of polishing slurry: 20°C
Polishing time: 4 minutes

### [Table 1]

**Table 1**

| | Water-soluble polymer | | Zeta potential [mV] | Polishing removal rate [nm/min] | Water repelling distance [mm] |
|---|---|---|---|---|---|
| | Species | Mw | | | |
| Example 1 | HEC | 1,520,000 | -18.7 | 45.7 | 7.5 |
| Example 2 | HEC | 1,330,000 | -20.2 | 45.6 | 7.0 |
| Example 3 | HEC | 840,000 | -23.5 | 38.5 | 7.5 |
| Comparative Example 1 | HEC | 280,000 | -24.9 | 36.4 | 11.0 |

As shown in Table 1, in Examples 1 to 3 each of which used the polishing composition having a zeta potential of -24.0 mV or more, the polishing removal rate was improved, the water repelling distance of the polished surface of the silicon wafer was reduced, and the wettability was improved compared to Comparative Example 1 in which the polishing composition has a zeta potential of less than -24.0 mV

Although specific examples of the present invention have been described in detail above, they are merely examples and do not limit the scope of the claims. The techniques described in the claims include those in which the specific examples exemplified above are variously modified and changed.

## Claims

1. A polishing composition for silicon wafer, the polishing composition comprising an abrasive, a cellulose derivative, a basic compound, and water, wherein the polishing composition has a zeta potential of -24.0 mV or more.

2. The polishing composition according to claim 1, wherein the cellulose derivative has a weight average molecular weight of more than 80 × 10⁴.

3. The polishing composition according to claim 1 or 2, wherein a content of the cellulose derivative is 0.1 to 20 parts by weight per 100 parts by weight of the abrasive.

4. The polishing composition according to any one of claims 1 to 3, wherein a content of the basic compound is 0.001% by weight or more and less than 0.1% by weight.

5. The polishing composition according to any one of claims 1 to 4, wherein the polishing composition has a pH of 8.0 or more and 12.0 or less.

6. The polishing composition according to any one of claims 1 to 5, wherein the abrasive is silica particles.

7. The polishing composition according to claim 6, wherein the silica particles have an average primary particle diameter of 5 nm or more and 100 nm or less.

8. The polishing composition according to any one of claims 1 to 7, in use for polishing a surface made of silicon.

9. The polishing composition according to any one of claims 1 to 8, in use for final polishing of a silicon wafer.

10. A method for polishing a silicon wafer, the method comprising a stock polishing step and a final polishing step, wherein in the final polishing step, a substrate to be polished is polished using a polishing composition comprising an abrasive, a cellulose derivative, a basic compound, and water, and having a zeta potential of -24.0 mV or more.
